# EUROPEAN PATENT SPECIFICATION

(11) **EP 4 064 367 B1**
(45) Date of publication and mention of the grant of the patent: **06.11.2024**
(21) Application number: 19953507.1
(22) Date of filing: 30.12.2019
(51) Int. Cl.: H01L 31/0216

(54) **PARTIAL TUNNELING OXIDE LAYER PASSIVATION CONTACT STRUCTURE OF PHOTOVOLTAIC CELL AND PHOTOVOLTAIC MODULE**
PARTIELLE TUNNELUNG EINER OXIDSCHICHTPASSIVIERUNGSKONTAKTSTRUKTUR EINER FOTOVOLTAISCHEN ZELLE UND FOTOVOLTAISCHES MODUL
STRUCTURE DE CONTACT DE PASSIVATION DE COUCHE D'OXYDE À EFFET TUNNEL PARTIEL DE CELLULE PHOTOVOLTAÏQUE ET MODULE PHOTOVOLTAÏQUE

(30) Priority: 20.11.2019 CN 201911142103; 20.11.2019 CN 201922019213 U
(43) Date of publication of application: 28.09.2022
(73) Proprietor: ZHEJIANG JINKO SOLAR CO., LTD., Haining, Zhejiang 314416 (CN); JINKO SOLAR CO., LTD., ShangRao, Jiangxi 334100 (CN)
(72) Inventor: YANG, Jie, Haining, Zhejiang 314416 (CN); SUN, Haijie, Haining, Zhejiang 314416 (CN); WANG, Zhao, Haining, Zhejiang 314416 (CN); XU, Menglei, Haining, Zhejiang 314416 (CN); ZHENG, Peiting, Haining, Zhejiang 314416 (CN); ZHANG, Xinyu, Haining, Zhejiang 314416 (CN); JIN, Hao, Haining, Zhejiang 314416 (CN)
(74) Representative: Novagraaf International SA
(86) International application number: PCT/CN2019/129771
(87) International publication number: WO 2021/098018

(56) References cited:
- CN-A- 107 195 699
- CN-A- 108 666 393
- CN-A- 109 524 480
- CN-A- 110 137 274
- CN-A- 110 137 274
- US-A1- 2013 247 965
- PEIBST ROBBY ET AL: "For none, one, or two polarities-How do POLO junctions fit best into industrial Si solar cells?", PROGRESS IN PHOTOVOLTAICS: RESEARCH AND APPLICATIONS, vol. 28, no. 6, 5 November 2019 (2019-11-05), Hoboken, USA, pages 503 - 516, XP055850862, ISSN: 1062-7995, DOI: 10.1002/pip.3201

## Description

### PRIORITY DOCUMENT

The present disclosure claims the priorities to Chinese patent applications No. 201911142103.0 and No. 201922019213.X, both titled "STRUCTURE OF PARTIAL TUNNEL OXIDE PASSIVATED CONTACT FOR PHOTOVOLTAIC CELL AND PHOTOVOLTAIC MODULE" and filed with the China National Intellectual Property Administration on November 20, 2019.

### FIELD

The present disclosure relates to the technical field of photovoltaic cells, in particular to a structure of partial tunnel oxide passivated contact for a photovoltaic cell and a photovoltaic module.

### BACKGROUND

Development of the solar photovoltaic market brings an increasingly urgent demand on a high-efficiency crystalline silicon cell. Continuous growth of the photovoltaic technology keeps reducing a manufacturing cost of the photovoltaic cells and renders market competition more fierce. Generally, a photovoltaic cell having high quality and a low cost is more competitive.

Surface passivation techniques for photovoltaic crystalline silicon is growing mature, and a degree of the passivation approaches its maximum. An open circuit voltage and conversion efficiency of the crystalline-silicon solar cell cannot be further improved mainly due to an excessive recombination current at a surface contact region between a metallic electrode and the crystalline silicon. Such current exceeds a recombination current at a non-metallic contact region by 2 orders of magnitude.

Tunnel oxide passivated contact is capable to suppress the recombination at the metallic contact region. In such structure, a silicon-based film has strong absorption on sunlight, which restricts application of the tunnel oxide passivated contact on a front surface of the crystalline silicon solar cells. Hence, the conversion efficiency of the crystalline silicon solar cells is hindered from further improvement.

CN110137274 relates to a preparation method of a double-sided passivation contact P-type high-efficiency battery. The preparation method comprises the following steps: S1, cleaning and texturing; S2,preparing frontal polysilicon; S3, preparing a mask; S4, etching; S5, diffusion; S6, cleaning; S7, annealing; S8, preparing a back polysilicon layer; S9, preparing a front SiNx antireflection layer;and S10. Printing. The invention also discloses the double-sided passivation contact P-type high-efficiency battery comprising P-type monocrystalline silicon. An N-type emitter is provided with a front ultra-thin silicon oxide layer far from the P-type monocrystalline silicon. A back ultra-thin silicon oxide layer is arranged on the back surface of the P-type monocrystalline silicon. The contact structure is passivated by using the tunnel oxide layer on the front and back surfaces of the battery so as to have great surface passivation effect. The silicon surface is passivated exactly under the front metal gate line and the back aluminum back field so as to avoid direct contact between the metal and the silicon base, reduce the surface recombination and improve the conversion efficiency of the battery.

The article "For none, one, or two polarities - How do POLO junctions fit best into industrial Si solar cells? " from Peibst et al., doi:10.1002/pip.3201, discloses cells with both tunnel oxide passivated contacts and a tunnel passivation surface, but not on the same surface of the cell.

### SUMMARY

An objective of the present disclosure is to provide a structure of partial tunnel oxide passivated contact for a photovoltaic cell and a photovoltaic module. The contact structure and the photovoltaic module which are compatible with conventional mass production techniques of crystalline-silicon cells, thus can be put into mass production quickly, and can lead to fast improvement of efficiency and fast reduction of costs. The invention is set out in the appended set of claims.

In order to address the above technical issues, a structure of partial tunnel oxide passivated contact for a photovoltaic cell is provided according to an embodiment of the present disclosure. The structure includes a cell body, a first tunnel oxide layer disposed on a surface of the cell body, and a first polysilicon film disposed on a surface of the tunnel oxide layer, where the surface of the cell body has a region for passivated contact and a region for light absorption, the first tunnel oxide layer is disposed in the region for passivated contact, and a projection of the first polysilicon film on the surface of the cell body is located in the region for passivated contact.

In an embodiment, the structure further includes a second tunnel oxide layer and a second polysilicon film that are disposed between the first tunnel oxide layer and the cell body layer, where both a projection of the second tunnel oxide layer and a projection of the second polysilicon film on the cell body cover the region for passivated contact and the region for light absorption.

In an embodiment, both a thickness of the first tunnel oxide layer and a thickness of the second tunnel oxide layer range from 0.5nm to 5nm.

In an embodiment, a thickness of the first polysilicon film ranges from 20nm to 300nm.

In an embodiment, a thickness of the second polysilicon film ranges from 5nm to 50nm.

In an embodiment, a thickness of the first tunnel oxide layer is equal to a thickness of the second tunnel oxide layer.

In an embodiment, the cell body is of a single-sided cell or a double-sided cell.

A photovoltaic module is further provided according to an embodiment of the present disclosure. The photovoltaic module includes a cell body and the forgoing structure that is disposed on the cell body.

The structure of partial tunnel oxide passivated contact for the photovoltaic cell and the photovoltaic module according to embodiments of the present disclosure have following advantages over conventional technology.

In the structure and the photovoltaic module according to embodiments of the present disclosure, the first tunnel oxide layer and the first polysilicon film merely cover the region for passivated contact, which improves a degree of passivation in such region, and suppress recombination at a surface of a cell. The first tunnel oxide layer and the first polysilicon film are not disposed in the region for light absorption, i.e., a region of non-metallic contact, which reduces blockage on sunlight and improves light absorption efficiency. The structure and the photovoltaic module are compatible with conventional mass production techniques of the crystalline-silicon cells, thus can be put into mass production quickly, and can lead to fast improvement of efficiency and fast reduction of costs.

### BRIEF DESCRIPTION OF THE DRAWINGS

For clearer illustration of the technical solutions according to embodiments of the present disclosure or conventional techniques, hereinafter are briefly described the drawings to be applied in embodiments of the present disclosure or conventional techniques. Apparently, the drawings in the following descriptions are only some embodiments of the present disclosure, and other drawings may be obtained by those skilled in the art based on the provided drawings without creative efforts.
Figure 1 is a schematic diagram showing a structure of partial tunnel oxide passivated contact for a photovoltaic cell according to an embodiment not part of the invention.
Figure 2 is a schematic diagram showing a structure of partial tunnel oxide passivated contact for a photovoltaic cell according to another embodiment part of the invention.

### DETAILED DESCRIPTION

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

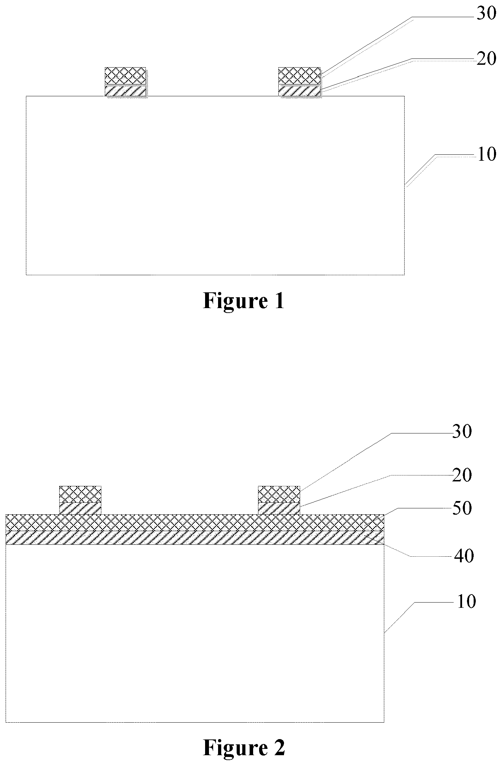

Reference is made to Figures 1 and 2. Figure 1 is a schematic diagram showing a structure of partial tunnel oxide passivated contact for a photovoltaic cell according to an embodiment of the present disclosure. Figure 2 is a schematic diagram showing a structure of partial tunnel oxide passivated contact for a photovoltaic cell according to another embodiment of the present disclosure.

In a specific embodiment, a structure of partial tunnel oxide passivated contact for a photovoltaic cell includes a cell body 10, a first tunnel oxide layer 20 disposed on a surface of the cell body 10, and a first polysilicon film 30 disposed on a surface of the tunnel oxide layer. The surface of the cell body 10 includes a region for passivated contact and a region for light absorption. The first tunnel oxide layer 20 is disposed in the region for passivated contact, and a projection of the first polysilicon film 30 on the surface of the cell body 10 is located in the region for passivated contact.

The first tunnel oxide layer 20 and the first polysilicon film 30 merely cover the region for passivated contact, which improves a degree of passivation in such region, and suppress recombination at a surface of a cell. The first tunnel oxide layer 20 and the first polysilicon film 30 are not disposed in the region for light absorption, i.e., a region of non-metallic contact, which reduces blockage on sunlight and improves light absorption efficiency. The structure and the photovoltaic module are compatible with conventional mass production techniques of the crystalline-silicon cells, thus can be put into mass production quickly, and can lead to fast improvement of efficiency and fast reduction of costs.

In conventional technology, passivation contact cover the whole front side. In comparison, only a region of metallic contact is covered according to embodiments of the present disclosure, and thereby efficiency of a cell is improved.

A metallic electrode needs to be sintered on the surface of the first tunnel oxide layer 20 on a basis of the contact, and the first tunnel oxide layer 20 and the first polysilicon film 30 are quit thin. Hence, the first crystalline silicon thin film is apt to be burnt through during fabricating the metallic electrode, which might damage the cell body 10. Such damages may be prevented to further suppress recombination at the metallic contact region and improve a performance of the cell. Hence, in an embodiment, the structure of partial tunnel oxide passivated contact for the photovoltaic cell further includes a second tunnel oxide layer 40 and a second polysilicon film 50, which are disposed between the first tunnel oxide layer 20 and the cell body 10. Both a projection of the second tunnel oxide layer 40 and a projection of the second polysilicon film 50 on the cell body 10 cover the region for passivated contact and the region for light absorption.

In the above structure, doping concentration of the first polysilicon film 30 is greater than that of the second polysilicon film 50, which forms a "vertical conjunction" structure. The vertical conjunction in the passivated contact addresses incompatibility between complete passivation and light absorption, and incompatibility between the complete passivation and penetration damages due to the metallic electrode. Thereby, conversion efficiency of the cell is improved.

A thickness of the tunnel oxide layer and a manner of fabrication of the tunnel oxide layer are not limited herein. Generally, a thickness of the first tunnel oxide layer 20 and a thickness of the second tunnel oxide layer 40 both range from 0.5nm to 5nm.

A thickness of the silicon film of and a manner of depositing the silicon film are not limited herein. Generally, a thickness of the first polysilicon film 30 and a thickness of the second polysilicon film 50 both range from 20nm to 300nm.

Preferably, a thickness of the first tunnel oxide layer 20 is equal to a thickness of the second tunnel oxide layer 40.

Preferably, a thickness of the first polysilicon film 30 is equal to a thickness of the second polysilicon film 50.

In embodiments of the present disclosure, the cell body 10 may be a single-sided cell body 10 or a double-sided cell body 10.

In one embodiment, a process of fabricating the foregoing structure of partial tunnel oxide passivated contact for the photovoltaic cell is as follows.
(1) The first tunnel oxide layer 20 is formed on the surface of a silicon wafer. The silicon wafer may made of monocrystalline silicon or polycrystalline silicon, and the surface of the silicon wafer may be p-type doped or n-type doped. The surface of the silicon wafer may be subject to de-damage, polish or texturing. The first tunnel oxide layer 20 may be formed through thermal oxidation or thermal HNO₃ oxidation, or deposited through CVD. A thickness of the first tunnel oxide layer ranges from 0.5nm to 5nm.
(2) The first polysilicon film is fabricated on the first tunnel oxide layer 20. Specifically, the polysilicon film may be doped or intrinsic polysilicon. The polysilicon film may be fabricated through CVD, PVD, or chemical spin coating, and may or may not be annealed in a subsequent process. A thickness of the first polysilicon film ranges from 20nm to 300nm.
(3) An etching protection layer is deposited on a part of a surface of the first polysilicon film to protect a region in which the tunnel oxide passivated contact is to be retained. Specifically, the etching protection layer may be organic or inorganic, and the partial patterning may be implemented through inkjet printing or screen printing.
(4) The polysilicon film in the non-protected region is etched by using a first chemical liquid. Specifically, the first chemical liquid may be an alkali or a mixed alkali, which is capable to remove the first polysilicon film 30 but not remove the first tunnel oxide layer 20. Thereby, the etching can be stopped at the surface of the first tunnel oxide layer 20 to protect surface morphology of the cell body 10.
(5) The etching protection layer is removed by using a second chemical liquid. Specifically, it may be an acid or a mixed acid, and is capable to remove the etching protection layer while not damaging the first polysilicon layer 30.
(6) The first tunnel oxide layer 20 in the etching region is removed by using a third chemical liquid. Specifically, the third chemical liquid is an HF solution, and an etching rate may be controlled based on reaction time and concentration of the solution.

In another embodiment, a process of fabricating the foregoing structure of partial tunnel oxide passivated contact for the photovoltaic cell is as follows.
(1) The second tunnel oxide layer 40 is formed on the surface of a silicon wafer. The silicon wafer may made of monocrystalline silicon or polycrystalline silicon, and the surface of the silicon wafer may be p-type doped or n-type doped. The surface of the silicon wafer may be subject to de-damage, polish or texturing. The second tunnel oxide layer 40 may be formed through thermal oxidation or thermal HNO₃ oxidation, or deposited through CVD. A thickness of the second tunnel oxide layer ranges from 0.5nm to 5nm.
(2) The second polysilicon film is fabricated on the second tunnel oxide layer 40. The second polysilicon film may be doped or intrinsic polysilicon. The second polysilicon film may be fabricated through CVD, PVD, or chemical spin coating, and may or may not be annealed in a subsequent process. A thickness of the second polysilicon film ranges from 20nm to 300nm.
(3) The first tunnel oxide layer 20 is formed on the surface of the second polysilicon film. The silicon wafer may made of monocrystalline silicon or polycrystalline silicon, and the surface of the silicon wafer may be p-type doped or n-type doped. The surface of the silicon wafer may be subject to de-damage, polish or texturing. The first tunnel oxide layer 20 may be formed through thermal oxidation or thermal HNO₃ oxidation, or deposited through CVD. A thickness of the first tunnel oxide layer ranges from 0.5nm to 5nm.
(4) The first polysilicon film is fabricated on the first tunnel oxide layer 20. Specifically, the polysilicon film may be doped or intrinsic polysilicon. The polysilicon film may be fabricated through CVD, PVD, or chemical spin coating, and may or may not be annealed in a subsequent process. A thickness of the first polysilicon film ranges from 20nm to 300nm.
(5) An etching protection layer is deposited on a part of a surface of the first polysilicon film to protect a region in which the tunnel oxide passivated contact is to be retained. Specifically, the etching protection layer may be organic or inorganic, and the partial patterning may be implemented through inkjet printing or screen printing.
(6) The first polysilicon film 30 in the non-protected region is etched by using a first chemical liquid. Specifically, the first chemical liquid may be an alkali or a mixed alkali, which is capable to remove the first polysilicon film 30 but not remove the first tunnel oxide layer 20. Thereby, the etching can be stopped at the surface of the first tunnel oxide layer 20 to protect the first tunnel oxide layer 20.
(7) The etching protection layer is removed by using a second chemical liquid. Specifically, it may be an acid or a mixed acid, and is capable to remove the etching protection layer while not damaging the second polysilicon film 50 and the first polysilicon film 30.
(8) The first tunnel oxide layer in the etching region is removed by using a third chemical liquid. Generally, the third chemical liquid is an HF solution.

The above processes save a PECVD mask process when fabricating the structure of partial tunnel oxide passivated contact, and hence is simple. The above processes further save a laser etching process, and hence avoids damages on the silicon wafer substrate induced by a laser. The above processes can stop the etching on the polysilicon at the surface of the tunnel oxide layer, which protects the surface morphology of the silicon substrate and avoid re-texturing. The second foregoing process utilize the "vertical junction" structure in the passivated contact, which addresses incompatibility between complete passivation and light absorption and incompatibility between the complete passivation and penetration damages due to the metallic electrode. Thereby, conversion efficiency of the cell is improved. The second foregoing process save a PECVD mask process when fabricating the structure of partial tunnel oxide passivated contact, and hence is simple. The second foregoing process further save a laser etching process, and hence avoids damages induced by a laser on the ultra-thin passivated contact and the silicon wafer substrate. The second foregoing process can stop the etching on the polysilicon at the surface of the tunnel oxide layer, and can retain the ultra-thin passivated contact structure in the non-metallic contact region.

A photovoltaic module is further provided according to embodiments of the present disclosure. The photovoltaic module includes a cell body and the foregoing structure of partial tunnel oxide passivated contact for the photovoltaic cell, and the structure is disposed on the cell body.

The photovoltaic module including the forgoing structure has the same beneficial effects achieved by the forgoing structure. Hence, the beneficial effects are not repeated herein.

In view of the above, the structure of partial tunnel oxide passivated contact for the photovoltaic cell and the photovoltaic module are provided according to embodiments of the present disclosure. The first tunnel oxide layer and the first polysilicon film merely cover the region for passivated contact, which improves a degree of passivation in such region, and suppress recombination at a surface of a cell. The first tunnel oxide layer and the first polysilicon film are not disposed in the region for light absorption, i.e., a region of non-metallic contact, which reduces blockage on sunlight and improves light absorption efficiency. The structure and the photovoltaic module are compatible with conventional mass production techniques of the crystalline-silicon cells, thus can be put into mass production quickly, and can lead to fast improvement of efficiency and fast reduction of costs.

Hereinabove the structure of partial tunnel oxide passivated contact for the photovoltaic cell and the photovoltaic module are illustrated in detail according to embodiments of the present disclosure. The principles and implementations of the present disclosure are described herein by using specific embodiments, and the description of the above embodiments are only intended for helping understand the means and the core concept of the present disclosure. Those of ordinary skill in the art can made several improvements and modifications on the present disclosure without departing from the scope of the claims.

## Claims

1. A structure of partial tunnel oxide passivated contact for a photovoltaic cell, comprising:
a cell body (10);
a first tunnel oxide layer (20) on a surface of the cell body (10); and
a first polysilicon film (30) on a surface of the first tunnel oxide layer (20):
wherein the surface of the cell body (10) has a region for passivated contact and a region for light absorption, the first tunnel oxide layer (20) is disposed in the region for passivated contact, and a projection of the first polysilicon film (30) on the surface of the cell body (10) is located in the region for passivated contact;
**characterized in that** the structure further comprises:
a second tunnel oxide layer (40) on the surface of the cell body (10) and a second polysilicon film (50) on a surface of the second tunnel oxide layer (40), which are disposed between the first tunnel oxide layer (20) and the cell body (10), wherein:
both a projection of the second tunnel oxide layer (40) and a projection of the second polysilicon film (50) on the cell body (10) cover entirely the region for passivated contact and the region for light absorption.

2. The structure according to claim 1, wherein both a thickness of the first tunnel oxide layer (20) and a thickness of the second tunnel oxide layer (40) range from 0.5nm to 5nm.

3. The structure according to claim 2, wherein a thickness of the first polysilicon film (30) ranges from 20nm to 300nm.

4. The structure according to claim 2, wherein a thickness of the second polysilicon film (50) ranges from 20nm to 300nm.

5. The structure according to claim 4, wherein a thickness of the first tunnel oxide layer (20) is equal to a thickness of the second tunnel oxide layer (40).

6. The structure according to claim 5, wherein the cell body (10) is of a single-sided cell or a double-sided cell.

7. A photovoltaic module, comprising:
a cell body (10); and
the structure according to any one of claims 1 to 6, wherein the structure is disposed on the cell body (10).

## Patentansprüche

1. Struktur eines partiellen Tunneloxid-passivierten Kontakts für eine photovoltaische Zelle, umfassend:
einen Zellenkörper (10);
eine erste Tunneloxidschicht (20) auf einer Oberfläche des Zellenkörpers (10); und
einen ersten Polysiliziumfilm (30) auf einer Oberfläche der ersten Tunneloxidschicht (20);
wobei die Oberfläche des Zellenkörpers (10) eine Region für passivierten Kontakt und eine Region zur Lichtabsorption aufweist, wobei die erste Tunneloxidschicht (20) in der Region für passivierten Kontakt angeordnet ist und ein Vorsprung des ersten Polysiliziumfilms (30) auf der Oberfläche des Zellenkörpers (10) sich in der Region für passivierten Kontakt befindet;
**dadurch gekennzeichnet, dass** die Struktur ferner umfasst:
eine zweite Tunneloxidschicht (40) auf der Oberfläche des Zellenkörpers (10) und einen zweiten Polysiliziumfilm (50) auf einer Oberfläche der zweiten Tunneloxidschicht (40), die zwischen der ersten Tunneloxidschicht (20) und dem Zellenkörper (10) angeordnet sind, wobei:
sowohl ein Vorsprung der zweiten Tunneloxidschicht (40) als auch ein Vorsprung des zweiten Polysiliziumfilms (50) auf dem Zellenkörper (10) die Region für passivierten Kontakt und die Region zur Lichtabsorption vollständig bedecken.

2. Struktur nach Anspruch 1, wobei sowohl eine Dicke der ersten Tunneloxidschicht (20) als auch eine Dicke der zweiten Tunneloxidschicht (40) in einem Bereich von 0,5 nm bis 5 nm liegen.

3. Struktur nach Anspruch 2, wobei eine Dicke des ersten Polysiliziumfilms (30) in einem Bereich von 20 nm bis 300 nm liegt.

4. Struktur nach Anspruch 2, wobei eine Dicke des zweiten Polysiliziumfilms (50) in einem Bereich von 20 nm bis 300 nm liegt.

5. Struktur nach Anspruch 4, wobei eine Dicke der ersten Tunneloxidschicht (20) gleich einer Dicke der zweiten Tunneloxidschicht (40) ist.

6. Struktur nach Anspruch 5, wobei der Zellenkörper (10) von einer einseitigen Zelle oder einer doppelseitigen Zelle ist.

7. Photovoltaisches Modul, umfassend:
einen Zellenkörper (10); und
die Struktur nach einem der Ansprüche 1 bis 6, wobei die Struktur auf dem Zellenkörper (10) angeordnet ist.

## Revendications

1. Structure de contact passivé par oxyde tunnel partiel pour une cellule photovoltaïque, comprenant :
un corps de cellule (10) ;
une première couche d'oxyde tunnel (20) sur une surface du corps de cellule (10) ; et
un premier film de polysilicium (30) sur une surface de la première couche d'oxyde tunnel (20) ;
dans laquelle la surface du corps de cellule (10) a une région pour contact passivé et une région pour absorption de lumière, la première couche d'oxyde tunnel (20) est disposée dans la région pour contact passivé, et une projection du premier film de polysilicium (30) sur la surface du corps de cellule (10) est située dans la région pour contact passivé ;
**caractérisée en ce que** la structure comprend en outre :
une deuxième couche d'oxyde tunnel (40) sur la surface du corps de cellule (10) et un deuxième film de polysilicium (50) sur une surface de la deuxième couche d'oxyde tunnel (40), qui sont disposés entre la première couche d'oxyde tunnel (20) et le corps de cellule (10),
dans laquelle tant une projection de la deuxième couche d'oxyde tunnel (40) qu'une projection du deuxième film de polysilicium (50) sur le corps de cellule (10) couvrent entièrement la région pour contact passivé et la région pour absorption de lumière.

2. Structure selon la revendication 1, dans laquelle tant l'épaisseur de la première couche d'oxyde tunnel (20) que l'épaisseur de la deuxième couche d'oxyde tunnel (40) sont situées dans la plage allant de 0,5 nm à 5 nm.

3. Structure selon la revendication 2, dans laquelle l'épaisseur du premier film de polysilicium (30) est située dans la plage allant de 20 nm à 300 nm.

4. Structure selon la revendication 2, dans laquelle l'épaisseur du deuxième film de polysilicium (50) est située dans la plage allant de 20 nm à 300 nm.

5. Structure selon la revendication 4, dans laquelle l'épaisseur de la première couche d'oxyde tunnel (20) est égale à l'épaisseur de la deuxième couche d'oxyde tunnel (40).

6. Structure selon la revendication 5, dans laquelle le corps de cellule (10) est celui d'une cellule simple face ou d'une cellule double face.

7. Module photovoltaïque comprenant :
un corps de cellule (10) ; et
la structure selon l'une quelconque des revendications 1 à 6,
dans lequel la structure est disposée sur le corps de cellule (10).
